(19)

Europäisches Patentamt

European Patent Office

Office européen des brevets

(11) **EP 3 633 390 B1**

(12) **EUROPÄISCHE PATENTSCHRIFT**

(45) Veröffentlichungstag und Bekanntmachung des Hinweises auf die Patenterteilung:
**15.11.2023 Patentblatt 2023/46**

(21) Anmeldenummer: **19188538.3**

(22) Anmeldetag: **26.07.2019**

(51) Internationale Patentklassifikation (IPC):
*G01P 21/00* (2006.01)      *G01P 15/09* (2006.01)
*B61K 9/02* (2006.01)       *H10N 30/80* (2023.01)

(52) Gemeinsame Patentklassifikation (CPC):
**B61K 9/02; H10N 30/802;** G01P 21/00;
H10N 30/302

(54) **VERFAHREN UND VORRICHTUNG ZUR DETEKTION VON STÖRUNGEN EINES SENSORS**

METHOD AND DEVICE FOR DETECTING FAULTS OF A SENSOR

PROCÉDÉ ET DISPOSITIF DE DÉTECTION DES PERTURBATIONS D'UN CAPTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.10.2018 AT 508432018**

(43) Veröffentlichungstag der Anmeldung:
**08.04.2020 Patentblatt 2020/15**

(73) Patentinhaber: **Siemens Mobility Austria GmbH 1210 Wien (AT)**

(72) Erfinder:
• **Dejaco, Daniela**
  **8010 Graz (AT)**
• **Girstmair, Bernhard Lukas**
  **8010 Graz (AT)**
• **Grabner, Gerald**
  **8010 Graz (AT)**
• **Haigermoser, Andreas**
  **8455 Oberhaag (AT)**
• **Simon, Johannes**
  **8043 Graz (AT)**

(74) Vertreter: **Siemens Patent Attorneys Postfach 22 16 34 80506 München (DE)**

(56) Entgegenhaltungen:
WO-A1-2013/014686      CN-A- 104 237 845
DE-A1-102012 217 721   JP-A- 2001 209 444
US-A- 5 506 454

**Beschreibung**

Die Erfindung bezieht sich auf ein Verfahren zur Detektion von Störungen eines Sensors, insbesondere eines piezoelektrischen Sensors für Fahrzeuge, wobei mittels des Sensors Messungen durchgeführt, aus einem Datenspeicher des Sensors Entladezeit-Daten mit einer ersten Entladezeitkonstante des Sensors ausgelesen und entsprechende Messsignale sowie die Entladezeit-Daten an eine Recheneinheit übermittelt werden, wobei in der Recheneinheit eine Signalverarbeitung, eine Signalauswertung sowie eine Datenauswertung erfolgt und wobei Parameterwerte einer zeitabhängigen Entladefunktion bezüglich des Sensors ermittelt werden, aus der Entladefunktion eine zweite Entladezeitkonstante bestimmt wird und mittels Vergleich der ersten Entladezeitkonstante mit der zweiten Entladezeitkonstante Störungen, Fehler oder Schäden des Sensors detektiert werden.

Fahrzeuge, beispielsweise Schienenfahrzeuge, müssen eine hohe Fahrsicherheit aufweisen. Eine genaue Einschätzung und Vorhersage von technischen Zuständen von Fahrzeugen, Fahrwerken und weiteren Fahrzeugkomponenten ist daher wichtig.

Eine Diagnoseeinrichtung für ein Schienenfahrzeug ist in der aus dem Stand der Technik bekannten WO 2014/048768 A1 dargestellt, wobei Beschleunigungssensoren und ein auf einem Fahrwerk angeordnetes elektronisches Diagnosegerät vorgesehen sind. Entsprechende Diagnosen des Fahrwerks erfolgen auf Grundlage von Beschleunigungsmessungen, welche in dem Diagnosegerät ausgewertet werden.

Eine hohe Qualität sowie eine geringe Fehlerrate von Messungen sind für Fahrzeugdiagnosen wichtig. Insbesondere ist es erforderlich, dass Messfehler aufgrund von Störungen, Beschädigungen von Sensoren etc. erkannt und fehlerhafte Messwerte aus Diagnosevorgängen ausgeschlossen oder Einflüsse der Störungen auf die Messungen reduziert werden können.

Aus dem Stand der Technik ist hierzu beispielsweise die DE 10 2011 106 302 B3 bekannt, in welcher ein Verfahren zur Erkennung von Messfehlern von Sensoren beschrieben ist. Mittels eines Kalibrierverfahrens werden zunächst Sensorwerte bestimmt, mittels Inversion einer Messmatrix Kräfte und/oder Momente ermittelt und danach mittels Rücktransformation der Kräfte und/oder Momente Pseudosensorwerte berechnet. Die Sensorwerte werden mit den Pseudosensorwerten verglichen, um daraus einen möglichen Messfehler zu detektieren.

Dieser Ansatz weist in seiner bekannten Form den Nachteil auf, dass die Messfehler bzw. Störungen der Sensoren nur indirekt, d.h. mittels der Sensorwerte und der Pseudosensorwerte, erfasst werden.

Weiterhin sind in der US 5,506,454 A eine Vorrichtung und ein Verfahren zur Diagnose eines Beschleunigungssensors gezeigt, bei welchen ein Sensorfehler über kapazitive Änderungen zwischen einer beweglichen Elektrode und einer ruhenden Elektrode detektiert wird.

Die JP 2001 209444 A beschreibt eine Stromversorgungseinrichtung für einen Kondensator mit einem Voltmeter, welches zu zwei Zeitpunkten Spannungen misst. Mit den gemessenen zwei Spannungswerten sowie den zwei Zeitpunkten und einer Ladungs- und Entladungscharakteristik des Kondensators wird eine Zeitkonstante ermittelt, mit welcher eine verbleibende Lade- bzw. Entladezeitspanne bestimmt werden kann.

In der CN 104 237 845 A ist ein passiver Sensor offenbart, welcher zur Lokalisierungsfehlerermittlung auf Grundlage einer mittleren quadratischen Abweichung eingerichtet ist.

Die DE 10 2012 217721 A1 zeigt eine Diagnoseeinrichtung für ein Schienenfahrzeug mit Beschleunigungssensoren.

Ferner ist in der WO 2013/014686 A1 eine Informations- und/oder Diagnoseeinrichtung mit einem Energieversorgungsgerät, welches kinetische Energie aus Vibrationen in elektrische Energie umwandelt, dargestellt.

Der Erfindung liegt daher die Aufgabe zugrunde, ein gegenüber dem Stand der Technik weiterentwickeltes Verfahren anzugeben, welches eine genaue Detektion von Sensorstörungen unter Einbeziehung von Sensoreigenschaften ermöglicht.

Erfindungsgemäß wird diese Aufgabe gelöst mit einem Verfahren der eingangs genannten Art, bei dem mittels Filterung der Messsignale gefilterte Signale gebildet werden, wobei die Parameterwerte der zeitabhängigen Entladefunktion umfassend eine Zeitmatrix mit einer ersten Zeit, einer zweiten Zeit bis zu einer N-Zeit mittels Logarithmierung der gefilterten Signale ermittelt werden.

Dadurch wird eine Überwachung des Sensors und somit ein hohes Sicherheitsniveau sowie eine hohe Verfügbarkeit im Betrieb des Sensors bewirkt und eine Diagnose des Sensors ermöglicht.

Das Verfahren basiert auf einer Auswertung von Sensoreigenschaften, nämlich der ersten Entladezeitkonstante und der zweiten Entladezeitkonstante. Störungen des Sensors werden daher mit großer Sicherheit erkannt, wodurch deren Einflüsse auf die Messungen reduziert werden können.

Es ist günstig, wenn bei Detektion einer Störung, eines Fehlers oder eines Schadens des Sensors ein Warnereignis erzeugt wird.

Eine Visualisierung der Störung kann beispielsweise auf einer Anzeigeeinheit in einem Führerstand des Fahrzeugs oder in einem Wartungsstand erfolgen. Durch diese Maßnahme wird eine rasche Reaktion auf die Störung ermöglicht. Beispielsweise kann dadurch ein Sensortausch durch Auslösung einer Ersatzteilbeschaffung rechtzeitig vorbereitet werden.

Eine vorteilhafte Ausgestaltung erhält man, wenn die Messungen, die Signalverarbeitung, die Signalauswertung, die Datenauswertung, die Filterung, die Logarithmierung, eine Entladezeitkonstanten-Bildung und der Vergleich kontinuierlich durchgeführt werden.

Ist das erfindungsgemäße Verfahren beispielsweise in ein Diagnose- und Überwachungsgerät eines Fahrzeugs implementiert und überwacht der Sensor eine Fahrzeugkomponente (z.B. einen Dämpfer, ein Rad, eine Federvorrichtung etc.), so wird durch diese Maßnahme eine hohe Zuverlässigkeit und Verfügbarkeit eines entsprechenden Überwachungs- und Diagnoseverfahrens bezüglich dieser Fahrzeugkomponente bewirkt.

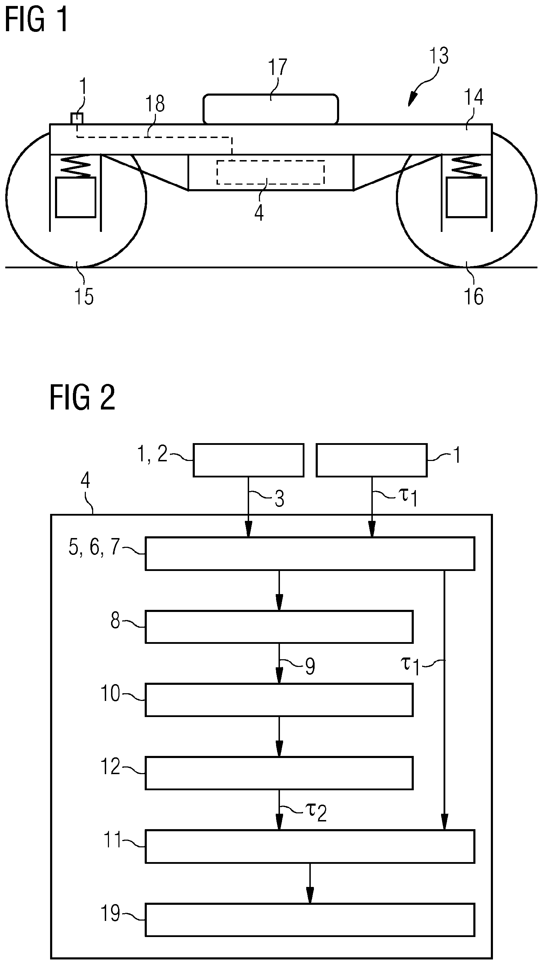

Fig. 1 zeigt ein Fahrwerk 13 eines als Schienenfahrzeug ausgeführten Fahrzeugs. Das Fahrwerk 13 umfasst einen primärgefederten Fahrwerksrahmen 14, welcher mit einem ersten Radsatz 15 und einem zweiten Radsatz 16 verbunden ist und auf welchem eine Sekundärfedervorrichtung 17 angeordnet ist. Das Fahrwerk 13 ist mit einem nicht gezeigten Wagenkasten verbunden.

Auf dem Fahrwerksrahmen 14 ist in einem Bereich über dem ersten Radsatz 15 ein Sensor 1 vorgesehen. Weiterhin ist auf dem Fahrwerksrahmen 14 eine Recheneinheit 4 angeordnet, welche über eine Leitung 18 mit dem Sensor 1 verbunden ist. Erfindungsgemäß ist es jedoch auch denkbar, dass die Recheneinheit 4 beispielsweise in dem Wagenkasten des Fahrzeugs vorgesehen ist und der Sensor 1 über entsprechende Leitungswege zwischen dem Fahrwerk 13 und dem Wagenkasten mit der Recheneinheit 4 verbunden ist.

Der Sensor 1, die Recheneinheit 4 und die Leitung 18 bilden ein Diagnose- und Überwachungsgerät des Schienenfahrzeugs, mittels dessen Beschleunigungen des Fahrwerksrahmens 14 ausgewertet und anhand ausgewerteter Beschleunigungsinformationen Defekte an Fahrzeugkomponenten (z.B. an einem Dämpfer) festgestellt werden.

Der Sensor 1 ist über die Recheneinheit 4 sowie die Leitung 18 mit Elektrizität versorgt. Über die Leitung 18 erfolgt weiterhin auch eine Datenübertragung zwischen dem Sensor 1 und der Recheneinheit 4.

Die Recheneinheit 4 ist mit einem Fahrzeug-Bordstromnetz sowie einem Fahrzeug-Borddatenbus, welche nicht dargestellt sind, verbunden.

Mittels des Sensors 1 sowie der Recheneinheit 4 wird eine im Zusammenhang mit Fig. 2 beschriebene, beispielhafte Ausführungsvariante eines erfindungsgemäßen Verfahrens durchgeführt.

Eine in Fig. 2 schematisch, als Flussdiagramm dargestellte, beispielhafte Ausführungsvariante eines erfindungsgemäßen, teilweise computerimplementierten Verfahrens ist in einem nicht gezeigten, als Schienenfahrzeug ausgeführten Fahrzeug implementiert.

Ein Sensor 1, welcher auch in Fig. 1 dargestellt und als piezoelektrischer Sensor 1 (Integrated Circuit Piezoelectric - Sensor, d.h. ICP-Sensor) ausgebildet ist, führt Messungen 2 von Beschleunigungen eines ebenfalls in Fig. 1 gezeigten Fahrwerksrahmens 14 durch. Entsprechende Messsignale 3 werden über eine in Fig. 1 dargestellte Leitung 18 an eine ebenfalls in Fig. 1 gezeigte Recheneinheit 4 übertragen.

Weiterhin werden über die Recheneinheit 4 aus einem Transducer Electronic Data Sheet (TEDS) eines Datenspeichers des Sensors 1 Entladezeit-Daten, welche eine erste Entladezeitkonstante $\tau_1$ des Sensors 1 umfassen, ausgelesen, d.h. über die Leitung 18 von dem Sensor 1 an die Recheneinheit 4 übertragen.

In der Recheneinheit 4 erfolgt eine Signalverarbeitung 5 und eine Signalauswertung 6 bezüglich der Messsignale 3, wobei Beschleunigungsinformationen bezüglich des Fahrwerksrahmens 14 aus den Messsignalen 3 extrahiert werden.

Weiterhin wird eine Datenauswertung 7 durchgeführt, über welche die genannte erste Entladezeitkonstante $\tau_1$ aus den Entladezeit-Daten extrahiert wird.

Weiterhin erfolgt eine als Bandpassfilterung ausgeführte Filterung 8 der Messsignale 3, wobei aus den Messsignalen 3 gefilterte Signale 9 gebildet werden.

Absolutbeträge der gefilterten Signale 9 werden mittels Logarithmierung 10 in Parameterwerte einer Entladefunktion b⁻ bezüglich des Sensors 1 übergeführt.

Die Messungen 2, die Signalverarbeitung 5, die Signalauswertung 6, die Datenauswertung 7, die Filterung 8 und die Logarithmierung 10 werden kontinuierlich während eines Betriebs des Fahrzeugs mit einer Frequenz von 10 Hz durchgeführt, wobei selbstverständlich auch geringere oder höhere Frequenzen denkbar sind.

Demnach wird mittels der beispielhaften Ausführungsvariante eines erfindungsgemäßen Verfahrens eine Vielzahl von Parameterwerten für die Entladefunktion b⁻ gebildet.

Die Entladefunktion b⁻ basiert auf einer exponentiellen ersten Bildungsvorschrift $y_1$ mit

$$y_1 = C \cdot \exp(-\frac{t}{\tau_2})$$

Die erste Bildungsvorschrift $y_1$ weist eine Konstante C, eine Zeit t sowie eine zweite Entladezeitkonstante $\tau_2$ auf und beschreibt einen Entladungsvorgang des Sensors 1. Eine auf der ersten Bildungsvorschrift $y_1$ basierende, lineare zweite Bildungsvorschrift $y_2$ lautet wie folgt:

$$y_2 = \log(C) + (-\frac{1}{\tau_2}) \cdot t$$

Die zweite Bildungsvorschrift $y_2$ weist eine Steigung k mit

$$k = -\frac{1}{\tau_2}$$

auf.

Die vektorwertige, zeitabhängige Entladefunktion $b^-$ mit einer ersten Komponente $b_1$ und einer zweiten Komponente $b_2$ ist aus der zweiten Bildungsvorschrift $y_2$ wie folgt gebildet:

$$b^- = \begin{pmatrix} \log(C) \\ \left(-\dfrac{1}{\tau_2}\right) \end{pmatrix} = (X^T X)^{-1} X \cdot y^- = \begin{pmatrix} ((X^T X)^{-1} X \cdot y^-)_1 \\ ((X^T X)^{-1} X \cdot y^-)_2 \end{pmatrix} = \begin{pmatrix} b_1 \\ b_2 \end{pmatrix}$$

Die Entladefunktion $b^-$ umfasst eine Zeitmatrix X mit einer ersten Zeit $t_1$, einer zweiten Zeit $t_2$ bis zu einer N-Zeit $t_N$, welche wie folgt definiert ist:

$$X = \begin{bmatrix} 1 & t_1 \\ 1 & t_2 \\ \vdots & \vdots \\ 1 & t_N \end{bmatrix}$$

Weiterhin weist die Entladefunktion $b^-$ einen Parametervektor $y^-$ mit einem ersten Parameterwert $y_{21}$, einem zweiten Parameterwert $y_{22}$ bis zu einem N-Parameterwert $y_{2N}$, welche mit der ersten Zeit $t_1$, der zweiten Zeit $t_2$ bis zu der N-Zeit $t_N$ korrelieren und aus den gefilterten Signalen 9 gebildet werden, auf, welcher folgendermaßen definiert ist:

$$y^- = \begin{bmatrix} y_{21} \\ y_{22} \\ \vdots \\ y_{2N} \end{bmatrix}$$

Die Parameterwerte entsprechen Funktionswerten der zweiten Bildungsvorschrift $y_2$.
Aus der Entladefunktion $b^-$ wird die Steigung k und aus der Steigung k die zweite Entladezeitkonstante $\tau_2$ mittels einer Methode der kleinsten Quadrate, wobei es sich um eine aus dem Stand der Technik bekannte Methode einer Ausgleichungsrechnung handelt, aus folgenden Zusammenhängen bestimmt (Entladezeitkonstanten-Bildung 12):

$$k = b_2 = ((X^T X)^{-1} X \cdot y^-)_2$$

$$\tau_2 = -\frac{1}{k}$$

Mittels eines Vergleichs 11 der ersten Entladezeitkonstante $\tau_1$ mit der zweiten Entladezeitkonstante $\tau_2$ werden ein Einschwingen von Messsignalen 3 und somit Störungen, Fehler oder Schäden des Sensors 1 detektiert.
Die Entladezeitkonstanten-Bildung 12 und der Vergleich 11 werden kontinuierlich mit einer Frequenz von 10 Hz durchgeführt, wobei natürlich auch kleinere oder größere Frequenzen einstellbar sind.
Erfindungsgemäß ist es auch denkbar, dass die Messungen 2 einerseits und die Signalverarbeitung 5, die Signalauswertung 6, die Datenauswertung 7, die Filterung 8, die Logarithmierung 10, die Entladezeitkonstanten-Bildung 12 sowie der Vergleich 11 andererseits mit unterschiedlichen Frequenzen durchgeführt werden.

Eine Störung, ein Fehler oder ein Schaden des Sensors 1 wird dann detektiert, wenn eine Differenz zwischen der ersten Entladezeitkonstante $\tau_1$ und der zweiten Entladezeitkonstante $\tau_2$ einen definierten ersten Grenzwert unterschreitet und wenn eine Wurzel einer mittleren Fehlerquadratsumme, d.h. ein Root Mean Square Error (RSME) der zweiten Entladezeitkonstante $\tau_2$ einen definierten zweiten Grenzwert unterschreitet.

Wird eine Störung, ein Fehler oder ein Schaden des Sensors 1 festgestellt, so wird ein Warnereignis bzw. ein Warnsignal erzeugt (Warnereignis-Erzeugung 19). Dieses wird von der Recheneinheit 4 über einen im Zusammenhang mit Fig. 1 beschriebenen Fahrzeug-Borddatenbus an einen Führerstand des Fahrzeugs geleitet und auf einer Anzeigeeinheit dargestellt. Erfindungsgemäß ist es auch möglich, das Warnsignal oder Informationen betreffend die erste Entladezeitkonstante $\tau_1$ und die zweite Entladezeitkonstante $\tau_2$ etc., d.h. Diagnose-und Überwachungssignale bezüglich des Sensors 1, über eine mit der Recheneinheit 4 verbundene und auf einem Dach des Fahrzeugs angeordnete Fahrzeugantenne mittels Funk an einen Wartungsstand mit entsprechender Empfangseinheit zur weiteren Auswertung auf einem Wartungsrechner, wobei eine Diagnose bzw. eine Rest-Standzeitprognose des Sensors 1 durchgeführt wird, zu übertragen.

Weiterhin ist es denkbar, den Sensor 1 nach Feststellung einer Störung, eines Fehlers oder eines Schadens auszuschalten, wofür die Recheneinheit 4 eine Stromversorgung des Sensors 1 über die Leitung 18, welche auch im Zusammenhang mit Fig. 1 beschrieben ist, deaktiviert.

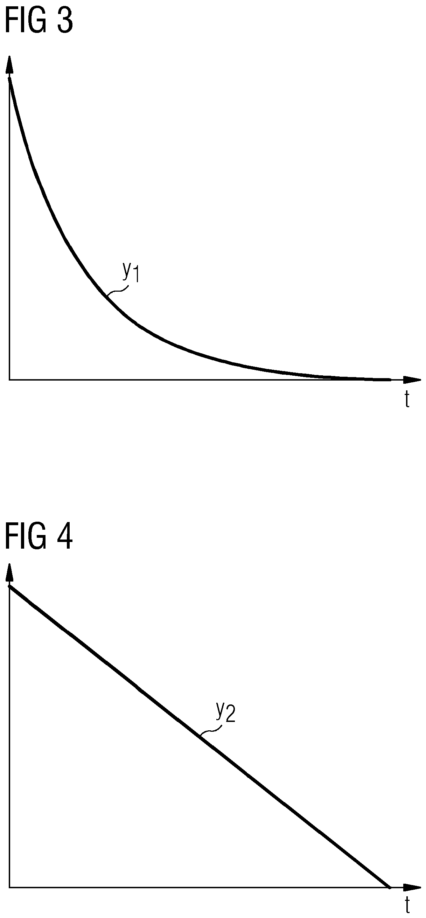

In Fig. 3 ist eine im Zusammenhang mit Fig. 2 beschriebene exponentielle erste Bildungsvorschrift $y_1$ als Basis einer ebenfalls im Zusammenhang mit Fig. 2 offenbarten Entladefunktion $b^-$ eines Sensors 1 als erstes Diagramm dargestellt.

Auf einer Abszisse des ersten Diagramms sind Zeiten t aufgetragen, auf einer Ordinate aus im Zusammenhang mit Fig. 2 genannten, gefilterten Signalen 9 extrahierte Funktionswerte.

In Fig. 4 ist eine im Zusammenhang mit Fig. 2 beschriebene lineare zweite Bildungsvorschrift $y_2$ für eine ebenfalls im Zusammenhang mit Fig. 2 offenbarte Entladefunktion $b^-$ eines Sensors 1 als zweites Diagramm dargestellt.

Auf einer Abszisse des zweiten Diagramms sind Zeiten t aufgetragen, auf einer Ordinate aus im Zusammenhang mit Fig. 2 genannten, gefilterten Signalen 9 mittels Logarithmierung 10 gebildete Funktionswerte. Die Funktionswerte entsprechen im Zusammenhang mit Fig. 2 beschriebenen Parameterwerten der Entladefunktion $b^-$.

Liste der Bezeichnungen

| | |
|---|---|
| 1 | Sensor |
| 2 | Messung |
| 3 | Messsignal |
| 4 | Recheneinheit |
| 5 | Signalverarbeitung |
| 6 | Signalauswertung |
| 7 | Datenauswertung |
| 8 | Filterung |
| 9 | Gefiltertes Signal |
| 10 | Logarithmierung |
| 11 | Vergleich |
| 12 | Entladezeitkonstanten-Bildung |
| 13 | Fahrwerk |
| 14 | Fahrwerksrahmen |
| 15 | Erster Radsatz |
| 16 | Zweiter Radsatz |
| 17 | Sekundärfedervorrichtung |
| 18 | Leitung |
| 19 | Warnereignis-Erzeugung |

| | |
|---|---|
| $\tau_1$ | Erste Entladezeitkonstante |
| $\tau_2$ | Zweite Entladezeitkonstante |
| $b^-$ | Entladefunktion |
| $y_1$ | Erste Bildungsvorschrift |
| $y_2$ | Zweite Bildungsvorschrift |
| C | Konstante |
| t | Zeit |

k    Steigung
$b_1$    Erste Komponente
$b_2$    Zweite Komponente
X    Zeitmatrix
$t_1$    Erste Zeit
$t_2$    Zweite Zeit
$t_N$    N-Zeit
$y^-$    Parametervektor
$y_{21}$    Erster Parameterwert
$y_{22}$    Zweiter Parameterwert
$y_{2N}$    N-Parameterwert

**Patentansprüche**

1. Verfahren zur Detektion von Störungen eines Sensors (1), insbesondere eines piezoelektrischen Sensors (1) für Fahrzeuge, wobei mittels des Sensors (1) Messungen (2) durchgeführt und entsprechende Messsignale (3) an eine Recheneinheit (4) übermittelt werden, wobei aus einem Datenspeicher des Sensors (1) Entladezeit-Daten mit einer ersten Entladezeitkonstante ($\tau_1$) des Sensors ausgelesen und an die Recheneinheit (4) übermittelt werden, wobei in der Recheneinheit (4) eine Signalverarbeitung (5), eine Signalauswertung (6) sowie eine Datenauswertung (7) erfolgt und wobei in der Recheneinheit (4) Parameterwerte einer zeitabhängigen Entladefunktion ($b^-$) bezüglich des Sensors ermittelt werden, aus der Entladefunktion ($b^-$) in der Recheneinheit (4) eine zweite Entladezeitkonstante ($\tau_2$) bestimmt wird und mittels Vergleich (11) der ersten Entladezeitkonstante ($\tau_1$) mit der zweiten Entladezeitkonstante ($\tau_2$) Störungen, Fehler oder Schäden des Sensors (1) detektiert werden, **dadurch gekennzeichnet, dass** in der Recheneinheit (4) mittels Filterung (8) der Messsignale (3) gefilterte Signale (9) gebildet werden, wobei die Parameterwerte der zeitabhängigen Entladefunktion ($b^-$) umfassend eine Zeitmatrix (X) mit einer ersten Zeit ($t_1$), einer zweiten Zeit ($t_2$) bis zu einer N-Zeit ($t_N$) mittels Logarithmierung (10) der gefilterten Signale (9) ermittelt werden.

2. Verfahren nach Anspruch 1, **dadurch gekennzeichnet, dass** die zweite Entladezeitkonstante ($\tau_2$) aus einer Steigung (k) der Entladefunktion ($b^-$) bestimmt wird.

3. Verfahren nach Anspruch 1 oder 2, **dadurch gekennzeichnet, dass** bei Detektion einer Störung, eines Fehlers oder eines Schadens des Sensors (1) ein Warnereignis erzeugt wird.

4. Verfahren nach einem der Ansprüche 1 bis 3, **dadurch gekennzeichnet, dass** die Messungen (2), die Signalverarbeitung (5), die Signalauswertung (6), die Datenauswertung (7), die Filterung (8), die Logarithmierung (10), eine Entladezeitkonstanten-Bildung (12) und der Vergleich (11) kontinuierlich durchgeführt werden.

5. Verfahren nach einem der Ansprüche 1 bis 4, **dadurch gekennzeichnet, dass** die zweite Entladezeitkonstante ($\tau_2$) mittels Ausgleichungsrechnung bestimmt wird.

6. Verfahren nach Anspruch 5, **dadurch gekennzeichnet, dass** eine Störung, ein Fehler oder ein Schaden des Sensors (1) dann detektiert wird, wenn eine Differenz zwischen der ersten Entladezeitkonstante ($\tau_1$) und der zweiten Entladezeitkonstante ($\tau_2$) einen definierten ersten Grenzwert unterschreitet und wenn eine Wurzel einer mittleren Fehlerquadratsumme der zweiten Entladezeitkonstante ($\tau_2$) einen definierten zweiten Grenzwert unterschreitet.

7. Fahrzeug eingerichtet zur Durchführung eines Verfahrens nach einem der Ansprüche 1 bis 6, wobei der Sensor (1), umfassend den Datenspeicher, zur Durchführung von Messungen (2) und die Recheneinheit (4) zur Signalverarbeitung (5), zur Signalauswertung (6) und zur Datenauswertung (7) auf dem Fahrzeug angeordnet sind, wobei der Sensor (1) und die Recheneinheit (4) dazu eingerichtet sind, Messignale (3) und Entladezeit-Daten mit einer ersten Entladezeitkonstante ($\tau_1$) des Sensors (1) an die Recheneinheit (4) zu übermitteln und wobei die Recheneinheit (4) zur Filterung (8) der Messignale (3), mittels welcher gefilterte Signale (9) gebildet werden, zur Logarithmierung (10) der gefilterten Signale (9), mittels welcher Parameterwerte einer zeitabhängigen Entladefunktion ($b^-$), umfassend eine Zeitmatrix (X) mit einer ersten Zeit ($t_1$), einer zweiten Zeit ($t_2$) bis zu einer N-Zeit ($t_N$), bezüglich des Sensors (1) ermittelt werden, zur Entladezeitkonstanten-Bildung (12), mittels welcher aus der Entladefunktion ($b^-$) eine zweite Entladezeitkonstante ($\tau_2$) bestimmt wird, sowie zum Vergleich (11) der ersten Entladezeitkonstante ($\tau_1$) mit der zweiten Entladezeitkonstante ($\tau_2$) zur Detektion von Störungen, Fehlern oder Schäden des Sensors (1) eingerichtet ist.

8. Fahrzeug nach Anspruch 7, **dadurch gekennzeichnet, dass** der Sensor (1) und die Recheneinheit (4) auf einem Fahrwerk (13) des Fahrzeugs vorgesehen sind.

9. Fahrzeug nach Anspruch 7, **dadurch gekennzeichnet, dass** der Sensor (1) auf einem Fahrwerk (13) des Fahrzeugs und die Recheneinheit (4) in oder auf einem Wagenkasten des Fahrzeugs vorgesehen sind.

10. Fahrzeug nach einem der Ansprüche 7 bis 9, **dadurch gekennzeichnet, dass** der Sensor (1) und die Recheneinheit (4) als Teile eines Diagnose- und Überwachungsgeräts des Fahrzeugs ausgebildet sind.

11. Fahrzeug nach einem der Ansprüche 7 bis 10, **dadurch gekennzeichnet, dass** die Recheneinheit (4) mit einer Anzeigeeinheit verbunden ist, auf welcher eine detektierte Störung, ein detektierter Fehler oder ein detektierter Schaden des Sensors (1) anzeigbar ist.

12. Fahrzeug nach einem der Ansprüche 7 bis 11, **dadurch gekennzeichnet, dass** eine auf oder in dem Fahrzeug angeordnete und mit der Recheneinheit (4) verbundene Antenne, welche zur Übertragung von Diagnose- und Überwachungssignalen bezüglich des Sensors (1) ausgebildet ist, vorgesehen ist.

**Claims**

1. Method for detecting errors of a sensor (1), in particular of a piezoelectric sensor (1) for vehicles, wherein by means of the sensor (1) measurements (2) are taken and corresponding measurement signals (3) are transmitted to a computing unit (4), wherein discharge time data with a first discharge time constant ($\tau_1$) of the sensor is read out from a data storage unit of the sensor (1) and is transmitted to the computing unit (4), wherein a signal processing (5), a signal evaluation (6) and a data evaluation (7) take place in the computing unit (4) and wherein parameter values of a time-dependent discharge function (b⁻) in relation to the sensor are determined in the computing unit (4), a second discharge time constant ($\tau_2$) is determined from the discharge function (b⁻) and by means of a comparison (11) of the first discharge time constant ($\tau_1$) and the second discharge time constant ($\tau_2$) errors, faults or damage of the sensor (1) are detected, **characterised in that** filtered signals are formed by means of filtering (8) of the measurement signals (3) in the computing unit (4), wherein the parameter values of the time-dependent discharge function (b⁻), comprising a time matrix (X) with a first time ($t_1$), a second time ($t_2$) up to an N time ($t_N$), are determined by means of a logarithmic function (10) of the filtered signals (9).

2. Method according to claim 1, **characterised in that** the second discharge time constant ($\tau_2$) is determined from a gradient (k) of the discharge function (b).

3. Method according to claim 1 or 2, **characterised in that** a warning event is generated upon detection of an error, a fault or damage of the sensor (1).

4. Method according to one of claims 1 to 3, **characterised in that** the measurements (2), the signal processing (5), the signal evaluation (6), the data evaluation (7), the filtering (8), the logarithmic function (10), a discharge time constant creation (12) and the comparison (11) are performed continuously.

5. Method according to one of claims 1 to 4, **characterised in that** the second discharge time constant ($\tau_2$) is determined by means of an equalisation sum.

6. Method according to claim 5, **characterised in that** an error, a fault or damage of the sensor (1) is detected when a difference between the first discharge time constant ($\tau_1$) and the second discharge time constant ($\tau_2$) falls below a defined first limit value and when a root mean square error of the second discharge time constant ($\tau_2$) falls below a defined second limit value.

7. Vehicle configured for performing a method according to one of claims 1 to 6, wherein the sensor (1), comprising the data storage unit, is arranged for carrying out measurements (2) and the computing unit (4) is configured for signal processing (5), for signal evaluation (6) and for data evaluation (7) on the vehicle, wherein the sensor (1) and the computing unit (4) are configured to transmit measurement signals (3) and discharge time data with a first discharge time constant ($\tau_1$) of the sensor (1) to the computing unit (4) and wherein the computing unit (4) is configured for filtering (8) the measurement signals (3), by means of which filtered signals (9) are formed, for performing a logarithmic function (10) on the filtered signals (9), by means of which parameter values of a time-dependent discharge function (b⁻), comprising a time matrix (X) with a first time ($t_1$), a second time ($t_2$) up to an N time ($t_N$), are determined in relation to the sensor (1), for discharge time constant creation (12), by means of which a second discharge time constant ($\tau_2$) is determined from the discharge function (b⁻), as well as for comparing (11) the first discharge time constant ($\tau_1$) with the second discharge time constant ($\tau_2$) to detect errors, faults or damage of the sensor (1).

8.  Vehicle according to claim 7, **characterised in that** the sensor (1) and the computing unit (4) are provided on a chassis (13) of the vehicle.

9.  Vehicle according to claim 7, **characterised in that** the sensor (1) is provided on a chassis (13) of the vehicle and the computing unit (4) is provided in or on a vehicle body of the vehicle.

10. Vehicle according to one of claims 7 to 9, **characterised in that** the sensor (1) and the computing unit (4) are designed as parts of a diagnostic and monitoring device of the vehicle.

11. Vehicle according to one of claims 7 to 10, **characterised in that** the computing unit (4) is connected to a display unit on which a detected error, a detected fault or a detected damage of the sensor (1) can be displayed.

12. Vehicle according to one of claims 7 to 11, **characterised in that** an antenna arranged on or in the vehicle and connected to the computing unit (4) is provided which is designed for transmitting diagnostic and monitoring signals in relation to the sensor (1).

**Revendications**

1.  Procédé de détection des perturbations d'un capteur (1), en particulier d'un capteur piézoélectrique (1) pour véhicules, dans lequel des mesures (2) sont effectuées au moyen du capteur (1) et des signaux de mesure correspondants (3) sont envoyés à une unité de calcul (4), dans lequel des données de décharge avec une première constante de temps de décharge ($\tau_1$) du capteur sont lues à partir d'une mémoire de données du capteur (1) et transmises à l'unité de calcul (4), dans lequel un traitement du signal (5), une évaluation du signal (6) ainsi qu'une évaluation des données (7) ont lieu dans l'unité de calcul (4), et dans lequel, dans l'unité de calcul (4), des valeurs de paramètres d'une fonction de décharge (b⁻) dépendant du temps sont déterminés par rapport au capteur, une deuxième constante de temps de décharge ($\tau_2$) est déterminée à partir de la fonction de décharge (b⁻) dans l'unité de calcul (4), et par comparaison (11) de la première constante de temps de décharge ($\tau_1$) avec la deuxième constante de temps de décharge ($\tau_2$), des perturbations, des erreurs ou des endommagements du capteur (1) sont détectés, **caractérisé en ce que** dans l'unité de calcul (4), des signaux (9) filtrés sont formés par filtrage (8) des signaux de mesure (3), dans lequel les valeurs de paramètres de la fonction de décharge (b⁻) dépendant du temps comprenant une matrice temporelle (X) avec un premier temps ($t_1$), un deuxième temps ($t_2$) jusqu'à un N-temps ($t_N$) sont déterminés par logarithmisation (10) des signaux filtrés (9).

2.  Procédé selon la revendication 1, **caractérisé en ce que** la deuxième constante de temps de décharge ($\tau_2$) est déterminée à partir d'une pente (k) de la fonction de décharge (b⁻).

3.  Procédé selon la revendication 1 ou 2, **caractérisé en ce que** lors de la détection d'une perturbation, d'une erreur ou d'un endommagement du capteur (1), un avertissement est émis.

4.  Procédé selon l'une des revendications 1 à 3, **caractérisé en ce que** les mesures (2), le traitement du signal (5), l'évaluation du signal (6), l'évaluation des données (7), le filtrage (8), la logarithmisation (10), une formation de constantes de décharge (12) et la comparaison (11) sont effectués en continu.

5.  Procédé selon l'une des revendications 1 à 4, **caractérisé en ce que** la deuxième constante de temps de décharge ($\tau_2$) est déterminée par calcul de compensation.

6.  Procédé selon la revendication 5, **caractérisé en ce qu'**une perturbation, une erreur ou un endommagement du capteur (1) est détecté(e) lorsqu'une différence entre la première constante de temps de décharge ($\tau_1$) et la deuxième constante de temps de décharge ($\tau_2$) est en-deçà d'une première valeur limite définie et lorsqu'une racine d'une somme des carrés des erreurs moyenne de la deuxième constante de temps de décharge ($\tau_2$) est en-deçà d'une deuxième valeur limite définie.

7. Véhicule conçu pour exécuter un procédé selon l'une des revendications 1 à 6, dans lequel le capteur (1), comprenant la mémoire de données, pour exécuter des mesures (2), et l'unité de calcul (4) pour le traitement du signal (5), l'évaluation du signal (6) et l'évaluation des données (7) sont disposés sur le véhicule, dans lequel le capteur (1) et l'unité de calcul (4) sont conçus pour transmettre des signaux de mesure (3) et des données de temps de décharge avec une première constante de temps de décharge ($\tau_1$) du capteur (1) à l'unité de calcul (4), et dans lequel l'unité de calcul (4) est conçue pour le filtrage (8) des signaux de mesure (3) au moyen duquel des signaux filtrés (9) sont formés, pour la logarithmisation (10) des signaux filtrés (9) au moyen de laquelle des valeurs de paramètres d'une fonction de décharge (b⁻) dépendant du temps, comprenant une matrice temporelle (X) avec un premier temps ($t_1$), un deuxième temps ($t_2$) jusqu'à un N-temps ($t_N$) par rapport au capteur (1), sont déterminés, pour la formation de constantes de décharge (12) au moyen de laquelle une deuxième constante de temps de décharge ($\tau_2$) est déterminée à partir de la fonction de décharge (b⁻), ainsi que pour la comparaison (11) de la première constante de temps de décharge ($\tau_1$) avec la deuxième constante de temps de décharge ($\tau_2$) pour détecter des perturbations, des erreurs ou des endommagements du capteur (1).

8. Véhicule selon la revendication 7, **caractérisé en ce que** le capteur (1) et l'unité de calcul (4) sont prévus sur un châssis (13) du véhicule.

9. Véhicule selon la revendication 7, **caractérisé en ce que** le capteur (1) est prévu sur un châssis (13) du véhicule et l'unité de calcul (4) dans ou sur une caisse de voiture du véhicule.

10. Véhicule selon l'une des revendications 7 à 9, **caractérisé en ce que** le capteur (1) et l'unité de calcul (4) font partie d'un appareil de diagnostic et de surveillance du véhicule.

11. Véhicule selon l'une des revendications 7 à 10, **caractérisé en ce que** l'unité de calcul (4) est reliée à une unité d'affichage sur laquelle une perturbation détectée, une erreur détectée ou un endommagement détecté du capteur (1) peut être affiché(e).

12. Véhicule selon l'une des revendications 7 à 11, **caractérisé en ce qu'**il est prévu une antenne disposée sur ou dans le véhicule et reliée à l'unité de calcul (4) qui est conçue pour transmettre des signaux de diagnostic et de surveillance par rapport au capteur (1).

FIG 1

FIG 2

FIG 3

$y_1$

t

FIG 4

$y_2$

t

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2014048768 A1
- DE 102011106302 B3
- US 5506454 A
- JP 2001209444 A
- CN 104237845 A
- DE 102012217721 A1
- WO 2013014686 A1